# EUROPEAN PATENT APPLICATION

(11) **EP 4 142 148 A1**
(43) Date of publication of application: **01.03.2023**
(21) Application number: 21193265.2
(22) Date of filing: 26.08.2021
(51) Int. Cl.: H02S 20/32, H01L 31/042

(54) **A SINGLE AXIS SOLAR TRACKER ABLE TO ADOPT A WIND-FAVOURABLE STOW POSITION**

(71) Applicant: CEP-IP Ltd, Cambridge, Cambridgeshire CB4 2HY (GB)
(72) Inventor: GRANT, Thomas McGregor James, Cambridge Cambridgeshire, CB4 2NR (GB)
(74) Representative: Torner, Juncosa I Associats, SL

(57) **Abstract**

The single axis solar tracker comprises photovoltaic panels (3) attached to two aligned torque tube sections (1a, 1b) with a longitudinal axis (30) and coupled to one another by a driftable coupling device (2) configured to transmit torque and to allow a certain rotational drift of one of the torque tube sections relative to the other, a plurality of support posts (4a, 4b, 4c) anchored to the ground and rotatably supporting the torque tube sections, two actuators (5a, 5b), each one operatively connected to rotate one of the torque tube sections, and an electronic control device (6) configured for controlling the two actuators so as to rotate the two torque tube sections synchronously in the same direction, for normal sun radiation collecting operation, or in opposite directions to a wind-favourable staggered stow position in which the photovoltaic panels are at a positive and negative stagger angles (+α, -α) to a reference stow plane (31).

## Description

### Technical field

The present invention generally relates to a single axis solar tracker and more in particular to a single axis solar tracked having a plurality of photovoltaic panels attached to a torque tube and provided with the ability of adopting a wind-favourable stow position in which some of the photovoltaic panels are at a positive stagger angle to a reference stow plane and others of the photovoltaic panels are at a negative stagger angle to the reference stow plane, with the reference stow plane being horizontal or slightly tilted to the horizontal.

### Background of the invention

Single axis solar trackers are known comprising an array of photovoltaic panels attached to a torque tube supported on a plurality of support posts anchored to the ground and an actuator operatively connected and controlled to rotate the torque tube together with the photovoltaic panels so as to follow the diurnal relative movement of the sun from a sunrise position to a sunset position and then to come back to the sunrise position.

In most single axis solar trackers the actuator is further controlled to rotate the torque tube together with the photovoltaic panels to a wind-favourable stow position when wind speed above a pre-set threshold is detected.

Document WO 2020198579 A2 discloses a solar canopy including a plurality of photovoltaic panels arranged in a static wind-favourable position in which the photovoltaic panels are alternately tilted clockwise and counter-clockwise with respect to an horizontal plane with a degree of tilt of 5° to 7° in order to reduce wind loading on the photovoltaic panels.

Document US 9905717 A discloses a photovoltaic solar installation comprising a plurality of single axis solar trackers arranged in parallel rows, wherein each single axis solar tracker comprises a torque tube rotatably supported on a plurality of support posts anchored to the ground and a row of coplanar photovoltaic panels attached to the torque tube. Each one of the plurality of single axis solar trackers is driven independently of each other to cause each row of photovoltaic panels to stow independently at a different or similar angle.

Document US 10340839 A discloses a single axis solar tracker comprising a torque tube rotatably supported on a plurality of support posts anchored to the ground, a row of coplanar photovoltaic panels attached to the torque tube, and an orientation motor operatively connected to rotate the torque tube sections together with the photovoltaic panels so as to follow the relative movements of the sun, wherein the orientation motor is further utilized to apply short pulses to the torque tube that dampen oscillations caused by wind buffeting the photovoltaic modules.

Document US 10594252 A discloses a single-axis solar tracker comprising a torque tube rotatably supported on a plurality of support posts anchored to the ground, a row of coplanar photovoltaic panels attached to the torque tube, and a driving device comprising two actuators operatively connected to the torque tube at positions thereof distant from each other. The two actuators are controlled by an electronic control device to simultaneously rotate in a first direction in order to make the torque tube together with the photovoltaic panels rotate so as to follow the relative movements of the sun from a sunrise position to a sunset position, or to simultaneously rotate in a second direction in order to come back to a sunrise position.

In the cited document US 10594252 A, the two actuators are optionally driven against each other to cause a desirable twisted or aerodynamic profile of the torque tube and associated photovoltaic panels, wherein the desired twisted or aerodynamic profiles can range from a substantially flat horizontal plate to a twisted helix-like profile so as to establish improved wind characteristics. As advantages, a reduction in structural materials and an increased structural strength are mentioned since the opposing twisted positions can create wind load-reducing effects including a reduction in wind load for a down-wind tracker and a reduction in vortex formation as a vortex created by a first tracker will counter a vortex created by an adjacent second tracker so as to destructively interfere and inhibit array-level vortex formation.

However, a drawback with the single axis solar tracker disclosed in the cited document US 10594252 A is that the fact of repeatedly forcing the torque tube and associated photovoltaic panels to a significant twisted helix-like profile would lead the photovoltaic panels to damage due to torsional stresses.

Documents GB 1318785 A, GB 2285301, and EP 0388244 A disclose respective driftable coupling devices configured for the transmission of an alternating torque between two mutually aligned torque tube sections and for allowing a pre-set amount of rotational drift of one of the torque tube sections relative to the other. The driftable coupling device disclosed in the cited document EP 0388244 A is further configured for alternatively and selectively allowing direct torque transmission from one shaft section to the other.

### Disclosure of the invention

The present invention contributes to mitigate the drawbacks of the prior art by providing a single axis solar tracker able to adopt a wind-favourable stow position in which a torque tube and associated photovoltaic panels of the solar tracker are tilted at stow opposite positive and negative angles and are subjected to none or slight torsional deformation.

The single axis solar tracker of the present invention comprises two or more torque tube sections substantially aligned with a longitudinal axis, a coupling device coupled between two of the torque tube sections and configured to transmit torque from one to the other of the two torque tube sections, one or more photovoltaic panels attached to each one of the two torque tube sections, a plurality of support posts anchored to the ground and rotatably supporting the torque tube sections, and driving arrangement comprising one or more actuators operatively connected to rotate the torque tube sections together with the photovoltaic panels about the longitudinal axis.

The solar tracker further comprises an electronic control device configured to control the one or more actuators so as to make the torque tube sections together with the photovoltaic panels rotate in a first direction from a sunrise position to a sunset position, in an opposite second direction from the sunset position back to the sunrise position, and, in the event a wind speed above a pre-determined threshold is detected, in the first and/or second direction to a wind-favourable stow position

According to the present invention, the coupling device is a driftable coupling device configured to allow a pre-set amount of rotational drift of one of the torque tube sections relative to the other, and the driving arrangement comprises two actuators, each one operatively connected to rotate one of the two torque tube sections.

Furthermore, the electronic control device is configured for controlling the two actuators so as to rotate the two torque tube sections synchronously in the same first or second direction, for normal sun radiation collecting operation, or to rotate one of the two torque tube sections in the first direction and the other in the opposite second direction to cause rotational drifting of the driftable coupling device until reaching a wind-favourable staggered stow position in which the photovoltaic panels attached to one of the two torque tube sections are at a positive stagger angle relative to a reference stow plane and the photovoltaic panels attached to the other of the two torque tube sections are at a negative angle relative to the reference stow plane, wherein the reference stow plane is at an angle from 0° to ±20° to the horizontal.

For example, the positive stagger angle and the angle to the reference stow plane at which the photovoltaic panels attached to the two torque tube sections are when the solar tracker is in the wind-favourable staggered stow position are from 5° to 20° and from -5° to -20°, respectively.

It has been found that the force of the wind effects different tipping loads on a single axis solar tracker: a first tipping load, tending to lift on support post off the ground, is due to horizontal component of wind, increases with higher tilt of the photovoltaic panels to the horizontal and is in same direction as the wind; and a second tipping load is created by the moment induced due to pressure differential across width of panel, increases with lower tilt of the photovoltaic panels to the horizontal and is always towards the ground irrespective of the wind direction. This second tipping load is only transmitted to the ground via the support post if the pivoting motion is stopped either due to the presence of a mechanical end stop or an actuator.

The staggered stow strategy of the present invention takes advantage of direction of the wind induced moment and creates opposing forces in the panel array to create a lower overall torque and increase stability

Thus, the use of the driftable coupling device and the two independent actuators to arrange the single axis solar tracker in the staggered stow position according to the present invention allows for a low tilt, low torque, stable wind-favourable stow position and yields a cheaper and more robust single axis solar tracking product.

In one embodiment, the driftable coupling device comprises two coupling members and a drift torque-transmitting element. The two coupling members are rigidly attached to adjacent ends of the two torque tube sections to be coupled and the drift torque-transmitting element is interposed between the two coupling members.

Each one of the two coupling members has one or more interference protrusions and the drift torque-transmitting element has one or more torque-transmitting protrusions configured to interfere with the interference protrusions of both two coupling members when one of the coupling members is rotated relative to the other for a drift angle corresponding to the pre-set amount of rotational drift. As a result, once the two coupling members are rigidly attached to the two torque tube sections, the torque-transmitting protrusions of the drift torque-transmitting element interfere with the interference protrusions of both two coupling members when one of the torque tube sections is rotated relative to the other for the drift angle.

For example, the drift angle corresponding to the pre-set amount of rotational drift allowed by the driftable coupling device is from 10° to 50°.

In one embodiment, the plurality of support posts includes a driftable coupling support post having two mutually facing support walls perpendicular to the longitudinal axis. Each one of the two support walls is interposed between the end of one of the two torque tube sections and one of the two coupling members of the driftable coupling device, and each one of the two coupling members is attached to the end of the corresponding one of the two torque tube sections by a connection shaft installed through a guide hole aligned with the longitudinal axis formed in the corresponding one of the two support walls of the driftable coupling support post.

Preferably, each one of the two coupling members has an axial limiting wall perpendicular to the longitudinal axis attached to the connection shaft and a surrounding cylindrical wall centred with the connection shaft and extending from the axial limiting wall in a direction opposite to the connection shaft. The two coupling members are coaxially arranged with free edges of their surrounding cylindrical walls facing each other, and wherein a distance from one to the other of the two support walls of the driftable coupling support post is selected so that the free edges of the surrounding cylindrical walls of the two coupling members are in contact or close proximity.

The two coupling members in combination define an inner space delimited by their axial limiting walls and their surrounding cylindrical walls, and the drift torque-transmitting element is housed in this inner space. The interference protrusions of each one of the two coupling members extend from the corresponding surrounding cylindrical wall towards a centre thereof. The drift torque-transmitting element has central portion and the torque-transmitting protrusions extend radially from the central portion. The torque-transmitting protrusions of the drift torque-transmitting element are arranged between the interference protrusions of the two coupling members, and a play corresponding to the drift angle is provided between the torque-transmitting protrusions and the interference protrusions.

In one embodiment, each one of the two torque tube sections comprises two or more torque tube stretches connected to one another by a direct coupling device configured to effect direct torque transmission from one of the two torque tube stretches to the other.

Preferably, the direct coupling device comprises two coupling members attached to adjacent ends of the two torque tube stretches and a direct torque-transmitting element interposed between the two coupling members. Each one of the two coupling members has one or more interference protrusions and the direct torque-transmitting element has one or more torque-transmitting protrusions configured to interfere constantly with the interference protrusions of both two coupling members.

In one embodiment, the plurality of support posts includes two direct coupling support posts each having two mutually facing support walls perpendicular to the longitudinal axis, wherein each one of the two support walls is interposed between the end of one of the two torque tube stretches of one of the two torque tube sections and one of the two coupling members of the corresponding direct coupling device. Each one of the two coupling members of each direct coupling device is attached to the end of the corresponding one of the two torque tube stretches by a connection shaft installed through a guide hole aligned with the longitudinal axis formed in the corresponding one of the two support walls of the corresponding direct coupling support post.

Preferably, each one of the two coupling members has an axial limiting wall perpendicular to the longitudinal axis attached to the connection shaft and a surrounding cylindrical wall centred with the connection shaft and extending from the axial limiting wall in a direction opposite to the connection shaft. The two coupling members are coaxially arranged with free edges of their surrounding cylindrical walls facing each other, a distance from one to the other of the two support walls of the direct coupling support post being selected so that the free edges of the surrounding cylindrical walls of the two coupling members are in contact or close proximity.

The two coupling members in combination define an inner space delimited by their axial limiting walls and their surrounding cylindrical walls, and the direct torque-transmitting element is housed in this inner space. The interference protrusions of each one of the two coupling members extend from the corresponding surrounding cylindrical wall towards a centre thereof, and the torque-transmitting protrusions of the direct torque-transmitting element extend radially from a central portion thereof. The torque-transmitting protrusions of the direct torque-transmitting element are arranged between the interference protrusions of the two coupling members with no play being provided therebetween.

Preferably, the two coupling members of each one of the two direct coupling devices are identical to each other and identical to the two coupling members of the driftable coupling device for easy of manufacturing, storing and mounting.

In one embodiment, the plurality of support posts includes two end support posts configured and arranged to rotatably support ends located farthest from the driftable coupling device of the two torque tube sections. The two actuators are supported on the two end support posts and operatively connected to the ends located farthest from the driftable coupling device of the two torque tube sections. When each of the torque tube sections is comprised of two or more torque tube stretches, the ends located farthest from the driftable coupling device of the two torque tube sections are the ends located farthest from the driftable coupling device of the two torque tube stretches located farthest from the driftable coupling device.

Preferably, the two actuators are linear actuators driven by electric motors controlled by the electronic control device.

The electronic control device is optionally further configured for controlling the two actuators so as to additionally rotate the ends of the two torque tube sections in the opposite first and second directions, from the wind-favourable staggered stow position, for respective twist angles so as to cause twisting of the torque tube sections and of the photovoltaic panels attached thereof until reaching a wind-favourable staggered and twisted stow position in which the photovoltaic panels attached to one of the two torque tube sections are at a positive stagger angle relative to the reference stow plane and twisted in a first twist direction and the photovoltaic panels attached to the other of the two torque tube sections are at a negative angle relative to the reference stow plane and twisted in an opposite second twist direction.

With the wind-favourable staggered and twisted stow position, in addition to the opposing effect mentioned above for the staggered stow position, the twisted surface of the photovoltaic panels deviates the wind flow in more than one direction, for example in different combinations of X, Y and Z directions in a coordinate system wherein X is the direction of the longitudinal axis, which is much more favourable from both a static pressure perspective, since virtually no torque due to the wind is appraised, and from a dynamic perspective, since very small vortices which are not likely to induce large amplitude vibrations are produced.

### Brief description of the drawings

The aforementioned features and advantages will be more fully understood from the following detailed description of some illustrative and non-limitative embodiments with reference to the accompanying drawings, in which:
Fig. 1 is a perspective view of a single axis solar tracker according to an embodiment of the present invention in a working position;
Fig. 2 is a perspective view of the single axis solar tracker in a wind-favourable staggered stow position;
Fig. 3 is a perspective view of the single axis solar tracker in a wind-favourable staggered and twisted stow position;
Fig. 4 is an elevational side view of the single axis solar tracker in the wind-favourable staggered stow position;
Fig. 5 is an elevational side view of the single axis solar tracker in a wind-favourable staggered and twisted stow position;
Fig. 6 a partial exploded perspective view of a driftable coupling device mounted on a driftable coupling support post and coupled between two torque tube sections of the single axis solar tracker;
Fig. 7 is a cross sectional view of the elements of Fig. 6 in an assembled position taken by a horizontal plane containing a longitudinal axis of the driftable coupling device and of torque tube sections;
Fig. 8 is an elevational front view of one of two coupling members of the driftable coupling device;
Fig. 9 is an elevational front view of a torque-transmitting element of the driftable coupling device configured to allow a rotational drift of 20° in cooperation with two coupling members as the one shown in Fig. 8;
Fig. 10 is a cross sectional view of the driftable coupling device taken by the plane X-X of Fig. 7 including two coupling members as the one shown in Fig. 8 and the torque-transmitting element of Fig. 9;
Fig. 11 is an elevational front view of an alternative torque-transmitting element of the driftable coupling device configured to allow a rotational drift of 40° in cooperation with two coupling members as the one shown in Fig. 8;
Fig. 12 is a cross sectional view of the driftable coupling device taken by the plane X-X of Fig. 7 but including in this case two coupling members as the one shown in Fig. 8 and the torque-transmitting element of Fig. 11;
Fig. 13 is an elevational front view of a direct torque-transmitting element for a direct coupling device configured to provide direct torque transmission in cooperation with two coupling members as the one shown in Fig. 8; and
Fig. 14 is a cross sectional view of the direct coupling device taken by a plane similar to the plane X-X of Fig. 7 including two coupling members as the one shown in Fig. 8 and the direct torque-transmitting element of Fig. 11.

### Detailed description of preferred embodiments

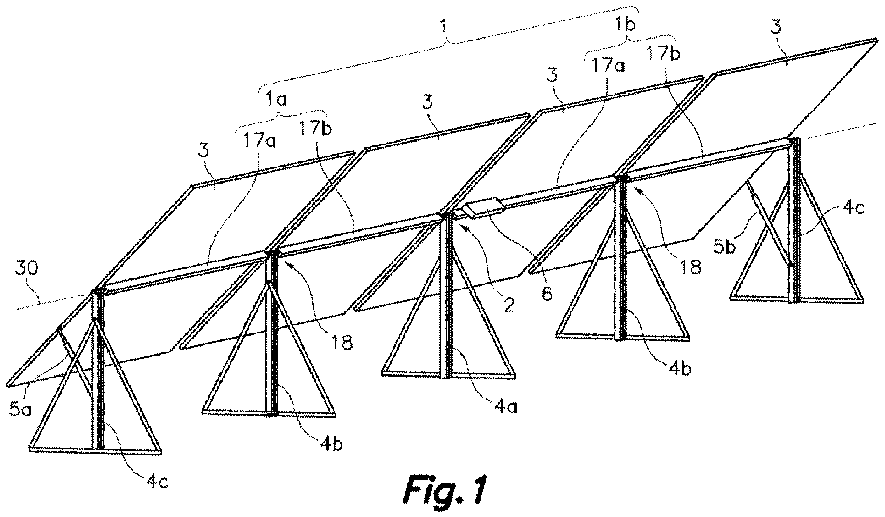

Referring first to Fig. 1, a single axis solar tracker able to adopt a wind-favourable stow position according to an embodiment of the present invention is shown.

The solar tracker has a torque tube 1 comprised of two torque tube sections 1a, 1b substantially aligned with a longitudinal axis 30, and each one of the two torque tube sections 1a, 1b is formed by two torque tube stretches 17a, 17b. The two torque tube sections 1a, 1b are coupled to one another by a driftable coupling device 2 configured to transmit torque from one to the other of the two torque tube sections 1a, 1b and to allow a pre-set amount of rotational drift of one of the torque tube sections 1a, 1b relative to the other. The two torque tube stretches 17a, 17b of each torque tube section 1a, 1b are connected to one another by a direct coupling device 18 configured to effect direct torque transmission from one of the two torque tube stretches 17a, 17b to the other.

Photovoltaic panels 3 are attached to the torque tube stretches 17a, 17b of the torque tube sections 1a, 1b, and a plurality of support posts 4a, 4b, 4c anchored to the ground are configured and arranged to rotatably support ends of the torque tube stretches 17a, 17b of the torque tube sections 1a, 1b as well as the driftable coupling device 2 and the direct coupling devices 18.

In the shown embodiment, the plurality of support posts include a central driftable coupling support post 4a configured and arranged to rotatably support the driftable coupling device 2 and adjacent ends of the two torque tube stretches 17a, 17b adjacent thereto, two intermediate direct coupling support posts 4b configured and arranged to rotatably support the direct coupling devices 18 and adjacent ends of the two torque tube stretches 17a, 17b adjacent thereto, and two end support posts 4c configured and arranged to rotatably support ends located farthest from the driftable coupling device 2 of the two torque tube stretches 17a, 17b located farthest from the driftable coupling device 2.

In an alternative embodiment (not shown), each one of the torque tube sections 1a, 1b may be comprised of more than two torque tube stretches connected between them by corresponding direct coupling devices 18 supported on respective direct coupling support posts 4b, with photovoltaic panels 3 being attached to each one of the torque tube stretches.

In another alternative embodiment (not shown), and given that the torque tube stretches 17a, 17b of each torque tube section 1a, 1b are connected to one another by one of the direct coupling devices 18 which provides direct torque transmission, each one of the torque tube sections 1a, 1b may be formed by one single torque tube stretch connected at one end to the driftable coupling device 2 supported on the driftable coupling support post 4a and rotatably supported at the other end on one of the end support posts 4c, so that the direct coupling devices 18 can be omitted with an equivalent result. If needed, the single torque tube stretch may be rotatably supported at one or more intermediate regions thereof by one or more bearings supported on corresponding bearing support posts.

The single axis solar tracker further includes a driving arrangement comprising two actuators 5a, 5b, each one operatively connected to rotate one of the torque tube sections 1a, 1b together with the corresponding photovoltaic panels 3 about the longitudinal axis 30, and an electronic control device 6 configured to control the two actuators 5a, 5b so as to make the torque tube sections 1a, 1b together with the respective photovoltaic panels 3 rotate synchronously in a first direction, from a sunrise position to a sunset position, and in an opposite second direction from the sunset position to the sunrise position, for normal sun radiation collecting operation.

In the embodiment shown in Figs. 1 to 5, the two actuators 5a, 5b are linear actuators driven by electric motors controlled by the electronic control device 6. However, according to the present invention any other kind of actuator can be alternatively used provided that it is electronically controllable by the electronic control device 6.

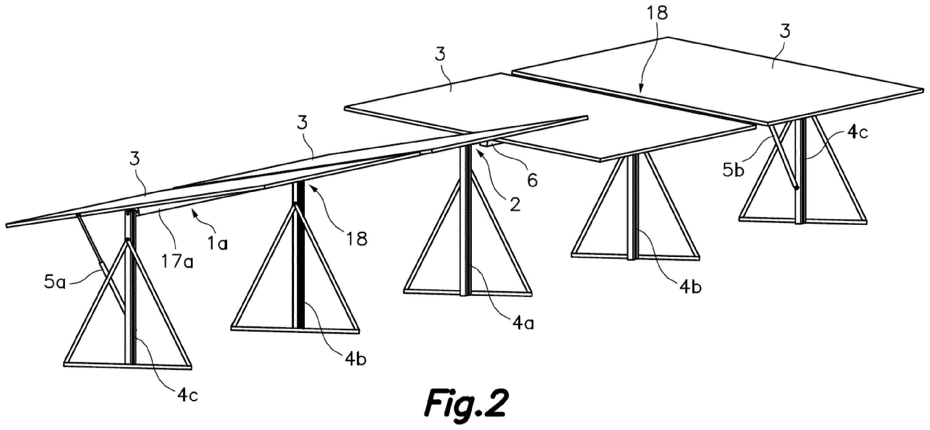

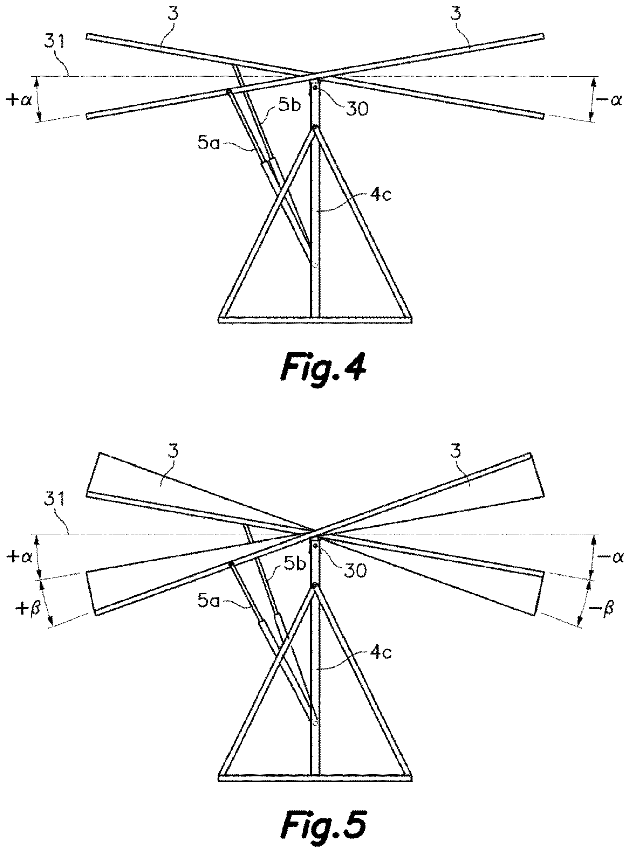

In the event that a wind speed above a pre-determined threshold is detected, for example by an anemometer (not shown) or by a warning message received from a weather service station, the electronic control device 6 is further configured to control the two actuators 5a, 5b so as to rotate one of the torque tube sections 1a in the first direction and the other torque tube section 1b in the opposite second direction to cause rotational drifting of the driftable coupling device 2 until reaching a wind-favourable staggered stow position (shown in Figs. 2 and 4) in which the photovoltaic panels 3 attached to one of the torque tube sections 1a are at a positive stagger angle +α with respect to a reference stow plane 31 (Fig. 4) and the photovoltaic panels 3 attached to the other of the torque tube sections 1b are at a negative stagger angle -α with respect to the reference stow plane 31.

The reference stow plane 31 is depicted as a horizontal plane in Figs 4 and 5. However, the reference stow plane 31 may be alternatively stablished at any angle from 0° to ±20° to the horizontal depending, for example, on the wind direction or the orographic conditions.

The positive stagger angle +α with respect to the reference stow plane 31 at which the photovoltaic panels 3 attached to one of the two torque tube sections 1a, 1b are in the wind-favourable staggered stow position is from 5° to 20°, and the negative stagger angle -α with respect to the reference stow plane at which the photovoltaic panels 3 attached to the other of the two torque tube sections 1a, 1b are in the wind-favourable staggered stow position is from -5° to -20°.

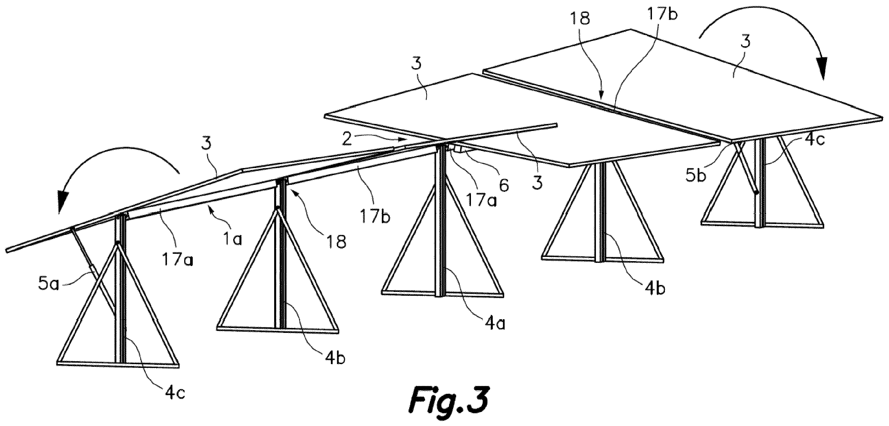

The solar tracker of the present invention is adapted to further achieve a staggered and twisted stow position, shown in Figs. 3 and 5, which is even more wind-favourable than the simply staggered stow position. To that end, the two actuators 5a, 5b are supported on the two end support posts 4c and operatively connected to the ends located farthest from the driftable coupling device 2 of the two torque tube sections 1a, 1b, and the electronic control device 6 is further configured to control the two actuators 5a, 5b so as to additionally rotate the end farthest from the driftable coupling device 2 of one of the torque tube sections 1a in the first direction for a positive twist angle +β in addition to the positive stagger angle +α and to additionally rotate the end farthest from the driftable coupling device 2 of the other one of the torque tube sections 1b in the second direction for a negative twist angle -β in addition to the negative stagger angle -α, as shown in Fig. 5.

As a result, and given that the ends connected to the driftable coupling device 2 of the torque tube sections 1a, 1b cannot rotate in the first and second directions beyond the respective positive and negative stagger angles +α and -α because the driftable coupling device 2 has reached its drift limit, the further rotation of the ends farthest from the driftable coupling device 2 of the torque tube sections 1a, 1b for the mentioned additional positive and negative twist angle +β and -β causes twisting of the torque tube sections 1a, 1b and of the photovoltaic panels 3 attaches thereto until reaching the wind-favourable staggered and twisted stow position.

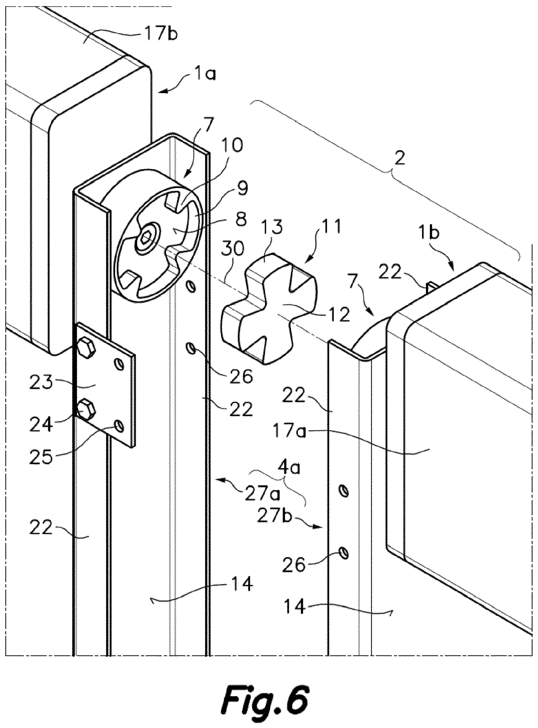

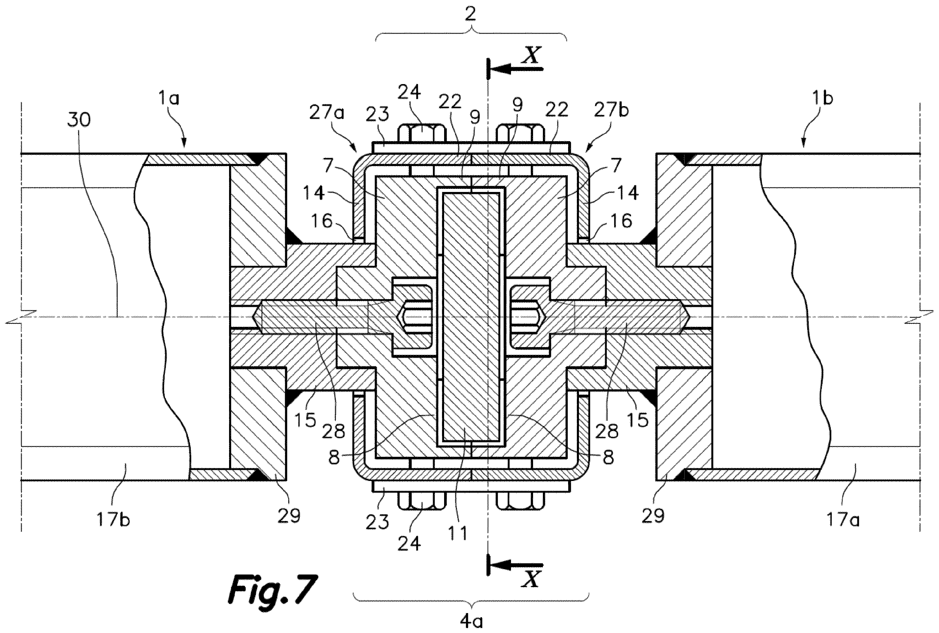

With reference now to Figs. 6 to 12, an embodiment of the driftable coupling device 2 with two variants is explained. As shown in Figs. 6 and 7, the driftable coupling device 2 comprises two coupling members 7 attached to adjacent ends of the two torque tube sections 1a, 1b and a drift torque-transmitting element 11 interposed between the two coupling members 7.

Each one of the two coupling members 7 has an axial limiting wall 8 and a surrounding cylindrical wall 9 extending therefrom. The axial limiting wall 8 is perpendicular to the longitudinal axis 30 and is attached to a connection shaft 15 aligned with the longitudinal axis 30, for example by a screw 28. The connection shaft 15 is rigidly connected to the adjacent end of the corresponding torque tube section 1a, 1b. For example, in the shown embodiment the connection shaft 15 is welded to an end plate 29 which in turn is welded to the corresponding torque tube stretch 17a, 17b. The surrounding cylindrical wall 9 is centred with the connection shaft 15 and extends from the axial limiting wall 8 in a direction opposite to the connection shaft 15.

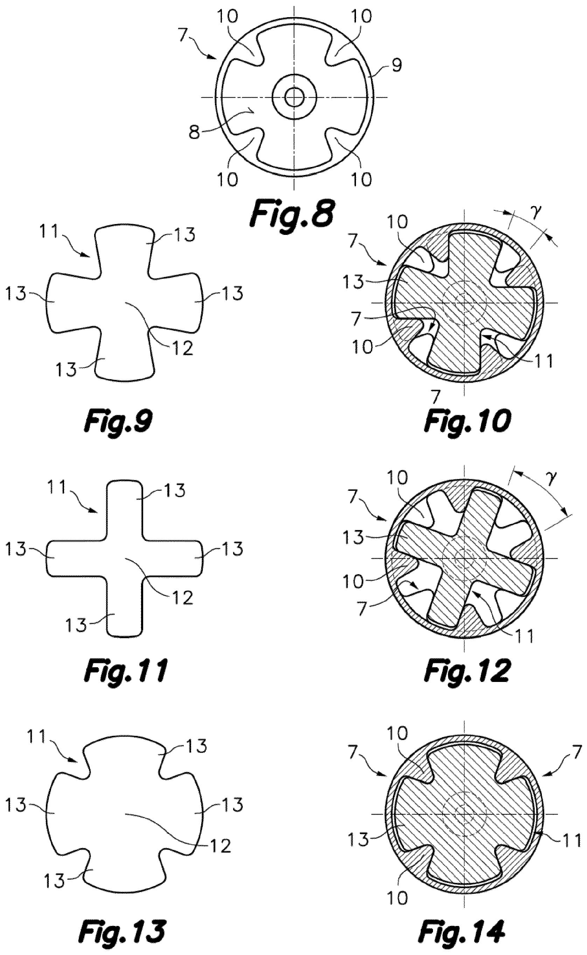

Interference protrusions 10 extend from the surrounding cylindrical wall 9 of each one of the two coupling members 7 towards a centre thereof (Fig. 8), and the drift torque-transmitting element 11 has torque-transmitting protrusions 13 extending radially from a central portion 12 thereof (Figs. 9 and 11). Preferably, the two coupling members 7 are mutually identical.

As better shown in Fig. 7, the two coupling members 7 are coaxially arranged so that free edges of their respective surrounding cylindrical walls 9 are facing each other so that the two coupling members 7 in combination define an inner space delimited by inner surfaces of their axial limiting walls 8 and their surrounding cylindrical walls 9. The drift torque-transmitting element 11 is housed in the inner space provided by the two facing coupling members 7 so that the torque-transmitting protrusions 13 of the torque-transmitting element 11 are arranged between the interference protrusions 10 of the two coupling members 7.

The torque-transmitting protrusions 13 of the drift torque-transmitting element 11 and the interference protrusions 10 of the coupling members 7 are configured so that a play corresponding to the drift angle γ is provided therebetween in the driftable coupling device 2 (Figs. 10 and 12). As a result, the torque-transmitting protrusions 13 of the drift torque-transmitting element 11 interfere with the interference protrusions 10 of both two coupling members 7 when one of the torque tube sections 1a is rotated relative to the other torque tube section 1b for a drift angle γ corresponding to the pre-set amount of rotational drift of the driftable coupling device 2.

The two drift torque-transmitting elements 11 shown in Figs. 9 and 11, respectively, correspond to two variants of the driftable coupling device 2 and are interchangeable to operate with the same two coupling members 7 as the one shown in Fig. 8.

As shown in Fig. 10, the torque-transmitting element 11 of Fig. 9 is configured in combination with the two facing coupling members 7 to provide a drift angle γ of 20°, thereby the resulting driftable coupling device 2 provides a rotational drift of 20°. Similarly, as shown in Fig. 12, the torque-transmitting element 11 of Fig. 11 is configured in combination with the same two facing coupling members 7 to provide a drift angle γ of 40°, thereby the resulting driftable coupling device 2 provides a rotational drift of 40°. In general, the drift angle γ corresponding to the pre-set amount of rotational drift allowed by the driftable coupling device 2 ranges for example from 10° to 50°.

With reference now to Figs. 13 and 14, an embodiment of the direct coupling device 18 is explained. The direct coupling device 18 comprises two facing coupling members 7, which are preferably identical to those described above in relation with the driftable coupling device 2, and a direct torque-transmitting element 19 (shown in Fig. 13) interposed between the two facing coupling members 7. The two facing coupling members 7 are attached to adjacent ends of the two adjacent torque tube stretches 17a, 17b of the two torque tube sections 1a, 1b by respective connection shafts 15 so that the two facing coupling members 7 provide together an inner space in which the direct torque-transmitting element 19 is arranged, the same way as shown in Figs. 6 and 7 for the driftable coupling device 2.

Interference protrusions 10 extend from a surrounding cylindrical wall 9 of each one of the two coupling members 7 towards a centre thereof (Fig. 8), and the direct torque-transmitting element 19 has torque-transmitting protrusions 20 extending radially from a central portion 21 thereof. The torque-transmitting protrusions 20 of the direct torque-transmitting element 19 are arranged between the interference protrusions 10 of the two coupling members 7 and are configured to closely fit between the interference protrusions 10 of the two facing coupling members 7 with no play being provided therebetween as shown in Fig. 14.

As a result, the torque-transmitting protrusions 20 of the direct torque-transmitting element 19 interfere constantly with the interference protrusions 10 of both two coupling members 7 so that when one of the torque tube sections 1a, 1b is rotated in either direction the rotary movement and torque is directly transmitted to the other torque tube section 1a, 1b by the direct coupling device 18.

Thus, a multipurpose coupling device may be provided comprising two facing coupling members 7 like that shown in Fig. 8, various interchangeable torque-transmitting elements 11 similar to those shown in Figs. 9 and 11 configured to provide various drift angles γ in combination with the two facing coupling members 7, and a direct torque-transmitting element 19 like that shown in Fig. 13 configured to provide direct torque transmission in combination with the two facing coupling members 7.

Thereby, by combining the two facing coupling members 7 with any one of the interchangeable torque-transmitting elements 11 a driftable coupling device 2 able to afford different rotational drifts between the coupling members 7 depending on the selected torque-transmitting element 11 is obtained, and by combining the two facing coupling members 7 with the direct torque-transmitting element 19 a direct coupling device 18 able to afford direct torque transmission from one coupling member 7 to the other is obtained.

It is to be noted that the driftable coupling device 2 and/or the multipurpose coupling device as disclosed above may be alternatively useful for different applications other than a single axis solar tracker, and that the direct coupling device 18 as disclosed above may be alternatively useful for a conventional single axis solar tracker with no staggered stow position.

Figs. 6 and 7 further show the constitution of the central driftable coupling support post 4a and the way how it rotatably supports the driftable coupling device 2 and the adjacent ends of the adjacent torque tube stretches 17a, 17b of the two torque tube segments 1a, 1b.

The driftable coupling support post 4a is comprised of two vertical members 27a, 27b having respective mutually facing support walls 14 perpendicular to the longitudinal axis 30 and side flanges 22 extending from vertical edges of the support walls 14. The side flanges 22 of one of the vertical members 27 extend to side flanges 22 of the other vertical member 27b and the two vertical members 27a, 27b are kept together by means of connection plates 23 attached to the respective side flanges 22 by screws 24 installed though corresponding holes 25, 26 formed in the connection plates 23 and in the side flanges 22.

The connection plates 23 are configured so that a distance from one to the other of the two support walls 14 is suitable to arrange the driftable coupling device 2 between the two mutually facing support walls 14 of the driftable coupling support post 4a and to keep the free edges of the surrounding cylindrical walls 9 of the two coupling members 7 of the driftable coupling device 2 in mutual contact or close proximity. Preferably, free edges of the side flanges 22 of the two members forming the driftable coupling support post 4a are also facing each other and in mutual contact or close proximity.

As shown in Fig. 7, each one of the two support walls 14 of the driftable coupling support post 4a has a guide hole 16 aligned with the longitudinal axis 30, and the connection shafts 15 rigidly connecting the two coupling members 7 of the driftable coupling device 2 to the adjacent ends of the torque tube sections 1a, 1b are installed through the guide holes 16, so that each support wall 14 is interposed between the end of one of the two torque tube sections 1a, 1b and one of the two coupling members 7 of the driftable coupling device 2.

Although not shown, the constitution of the direct coupling support posts 4b and the way how they rotatably support the direct coupling devices 18 and the adjacent ends of the adjacent torque tube stretches 17a, 17b of the two torque tube segments 1a, 1b is analogous to that shown and described above with reference to Figs 6 and 7 for the central driftable coupling support post 4a.

The scope of the present invention is defined in the attached claims.

## Claims

1. A single axis solar tracker able to adopt a wind-favourable stow position, the solar tracker comprising:
at least two torque tube sections (1a, 1b) aligned with a longitudinal axis;
a coupling device coupled between the two torque tube sections (1a, 1b) and configured to transmit torque from one to the other of the two torque tube sections (1a, 1b);
one or more photovoltaic panels (3) attached to each one of the torque tube sections (1a, 1b);
a plurality of support posts (4a, 4b, 4c) anchored to the ground and rotatably supporting the torque tube sections (1a, 1b);
a driving arrangement comprising at least one actuator (5) operatively connected to rotate the torque tube sections (1a, 1b) together with the photovoltaic panels (3) about the longitudinal axis; and
an electronic control device (6) configured to control the at least one actuator (5) so as to make the torque tube sections (1a, 1b) together with the photovoltaic panels (3) rotate in a first direction, from a sunrise position to a sunset position, in an opposite second direction from the sunset position to the sunrise position; and, in the event a wind speed above a pre-determined threshold is detected, in the first and/or second direction to a wind-favourable stow position;
**characterized in that**:
the coupling device is a driftable coupling device (2) configured to allow a pre-set amount of rotational drift of one of the torque tube sections (1a, 1b) relative to the other;
the driving arrangement comprises two actuators (5a, 5b), each one operatively connected to rotate one of the torque tube sections (1a, 1b); and
the electronic control device (6) is configured for controlling the two actuators (5a, 5b) so as to rotate the two torque tube sections (1a, 1b) synchronously in the same first or second direction, for normal sun radiation collecting operation, or to rotate one of the torque tube sections (1a, 1b) in the first direction and the other in the opposite second direction to cause rotational drifting of the driftable coupling device (2) until reaching a wind-favourable staggered stow position in which the photovoltaic panels (3) attached to one of the torque tube sections (1a, 1b) are at a positive stagger angle (+a) to a reference stow plane and the photovoltaic panels (3) attached to the other of the torque tube sections (1a, 1b) are at a negative stagger angle (-α) to the reference stow plane, the reference stow plane being at an angle from 0° to ±20° to the horizontal.

2. The single axis solar tracker according to claim 1, wherein the driftable coupling device (2) comprises two coupling members (7) attached to adjacent ends of the two torque tube sections (1a, 1b) and a drift torque-transmitting element (11) interposed between the two coupling members (7), and wherein each one of the two coupling members (7) has one or more interference protrusions (10) and the drift torque-transmitting element (11) has one or more torque-transmitting protrusions (13) configured to interfere with the interference protrusions (10) of both two coupling members (7) when one of the torque tube sections (1a, 1b) is rotated relative to the other for a drift angle (γ) corresponding to the pre-set amount of rotational drift.

3. The single axis solar tracker according to claim 2, wherein the plurality of support posts (4a, 4b, 4c) includes a driftable coupling support post (4a) having two mutually facing support walls (14) perpendicular to the longitudinal axis, wherein each one of the two support walls (14) is interposed between the end of one of the two torque tube sections (1a, 1b) and one of the two coupling members (7) of the driftable coupling device (2), and wherein each one of the two coupling members (7) is attached to the end of the corresponding one of the two torque tube sections (1a, 1b) by a connection shaft (15) installed through a guide hole (16) aligned with the longitudinal axis formed in the corresponding one of the two support walls (14) of the driftable coupling support post (4a).

4. The single axis solar tracker according to claim 3, wherein each one of the two coupling members (7) has an axial limiting wall (8) perpendicular to the longitudinal axis attached to the connection shaft (15) and a surrounding cylindrical wall (9) centred with the connection shaft (15) and extending from the axial limiting wall (8) in a direction opposite to the connection shaft (15), wherein the two coupling members (7) are coaxially arranged with free edges of their surrounding cylindrical walls (9) facing each other, and wherein a distance from one to the other of the two support walls (14) of the driftable coupling support post (4a) is selected so that the free edges of the surrounding cylindrical walls (9) of the two coupling members (7) are in contact or close proximity.

5. The single axis solar tracker according to claim 4, wherein the two coupling members (7) in combination define an inner space delimited by their axial limiting walls (8) and their surrounding cylindrical walls (9) and the drift torque-transmitting element (11) is housed in the inner space, and wherein the interference protrusions (10) of each one of the two coupling members (7) extend from the corresponding surrounding cylindrical wall (9) towards a centre thereof, and the torque-transmitting protrusions (13) of the drift torque-transmitting element (11) extend radially from a central portion (12) thereof and are arranged between the interference protrusions (10) of the two coupling members (7) with a play being provided therebetween corresponding to the drift angle (γ).

6. The single axis solar tracker according to any one of claims 1 to 5, wherein each one of the two torque tube sections (1a, 1b) comprises at least two torque tube stretches (17a, 17b) connected to one another by a direct coupling device (18) configured to effect direct torque transmission from one of the two torque tube stretches (17a, 17b) to the other.

7. The single axis solar tracker according to claim 6, wherein the direct coupling device (18) comprises two coupling members (7) attached to adjacent ends of the two torque tube stretches (17a, 17b) and a direct torque-transmitting element (19) interposed between the two coupling members (7), and wherein each one of the two coupling members (7) has one or more interference protrusions (10) and the direct torque-transmitting element (19) has one or more torque-transmitting protrusions (20) configured to interfere constantly with the interference protrusions (10) of both two coupling members (7).

8. The single axis solar tracker according to claim 7, wherein the plurality of support posts (4a, 4b, 4c) includes two direct coupling support posts (4b) each having two mutually facing support walls (14) perpendicular to the longitudinal axis, wherein each one of the two support walls (14) is interposed between the end of one of the two torque tube stretches (17a, 17b) of one of the two torque tube sections (2) and one of the two coupling members (7) of the corresponding direct coupling device (18), and wherein each one of the two coupling members (7) of each direct coupling device (18) is attached to the end of the corresponding one of the two torque tube stretches (17a, 17b) by a connection shaft (15) installed through a guide hole (16) aligned with the longitudinal axis formed in the corresponding one of the two support walls (14) of the corresponding direct coupling support post (4b).

9. The single axis solar tracker according to claim 8, wherein each one of the two coupling members (7) has an axial limiting wall (8) perpendicular to the longitudinal axis attached to the connection shaft (15) and a surrounding cylindrical wall (9) centred with the connection shaft (15) and extending from the axial limiting wall (8) in a direction opposite to the connection shaft (15), wherein the two coupling members (7) are coaxially arranged with free edges of their surrounding cylindrical walls (9) facing each other, and wherein a distance from one to the other of the two support walls (14) of the direct coupling support post (4b) is selected so that the free edges of the surrounding cylindrical walls (9) of the two coupling members (7) are in contact or close proximity.

10. The single axis solar tracker according to claim 9, wherein the two coupling members (7) in combination define an inner space delimited by their axial limiting walls (8) and their surrounding cylindrical walls (9) and the direct torque-transmitting element (19) is housed in the inner space, and wherein the interference protrusions (10) of each one of the two coupling members (7) extend from the corresponding surrounding cylindrical wall (9) towards a centre thereof, and the torque-transmitting protrusions (20) of the direct torque-transmitting element (19) extend radially from a central portion (21) thereof and are arranged between the interference protrusions (10) of the two coupling members (7) with no play being provided therebetween.

11. The single axis solar tracker according to any one of claims 1 to 10, wherein the plurality of support posts (4a, 4b, 4c) includes two end support posts (4c) configured and arranged to rotatably support ends located farthest from the driftable coupling device (2) of the two torque tube sections (1a, 1b), and wherein the two actuators (5a, 5b) are supported on the two end support posts (4c) and operatively connected to the ends located farthest from the driftable coupling device (2) of the two torque tube sections (1a, 1b).

12. The single axis solar tracker according to claim 11, wherein the electronic control device (6) is further configured for controlling the two actuators (5a, 5b) so as to additionally rotate the ends of the two torque tube sections (1a, 1b) in the opposite first and second directions, from the wind-favourable staggered stow position, for respective twist angles so as to cause twisting of the torque tube sections (1a, 1b) and of the photovoltaic panels (3) attached thereof.

13. The single axis solar tracker according to claim 11 or 12, wherein the two actuators (5a, 5b) are linear actuators driven by electric motors controlled by the electronic control device (6).

14. The single axis solar tracker according to claim 7, wherein the two coupling members (7) of each one of the two direct coupling devices (18) are identical to the two coupling members (7) of the driftable coupling device (2).

15. The single axis solar tracker according to claim 2, wherein the drift angle (γ) corresponding to the pre-set amount of rotational drift allowed by the driftable coupling device (2) is from 10° to 50°, the positive stagger angle (+a) to the reference stow plane at which the photovoltaic panels (3) attached to one of the two torque tube sections (1a, 1b) are in the wind-favourable staggered stow position is from 5° to 20°, and the negative stagger angle (-α) to the reference stow plane at which the photovoltaic panels (3) attached to the other of the two torque tube sections (1a, 1b) are in the wind-favourable staggered stow position is from -5° to -20°.
